# EUROPEAN PATENT APPLICATION

(11) **EP 2 123 969 A1**
(43) Date of publication of application: **25.11.2009**
(21) Application number: 08703045.8
(22) Date of filing: 10.01.2008
(51) Int. Cl.: F21S 2/00, F21V 8/00, G02B 6/00, G09F 13/18, H01H 9/18, H01H 13/02, F21Y 101/02

(54) **ILLUMINATING DEVICE, AND INPUT DEVICE HAVING THE FORMER**

(30) Priority: 15.01.2007 JP 2007005676
(71) Applicant: Alps Electric Co., Ltd., Ota-ku Tokyo 145-8501 (JP)
(72) Inventor: ITO, Naoki, Tokyo 145-8501 (JP); OKAMOTO, Jun, Tokyo 145-8501 (JP)
(74) Representative: Waibel, Stefan Christopher
(86) International application number: PCT/JP2008/050174
(87) International publication number: WO 2008/087883

(57) **Abstract**

[Object] To provide a thin illumination device capable of efficiently utilizing light emitted from a light source, and an input device equipped with the illumination device.

[Means for Solution] A recess portion 2a is formed in a substrate 2 to accommodate a light emitting element 6 so as to be sealed with a sealant 9. A light guide layer 4 formed of a thin transparent resin film is fixed onto the substrate 2 via an adhesive layer 3 to realize an illuminating device 1A with a thin structure. The light emitted from the light emitting element 6 is irradiated into the light guide layer 4 via the sealant 9 and the adhesive layer 3. The light fully reflecting on the boundary surfaces between the light guide layer 4 and the adhesive layer 3, and between the light guide layer 4 and the air layer 5 passes inside the light guide layer 4. Then the light which has not fully reflected leaks outside from the surface of the transparent resin film which forms the light guide layer 4. This makes it possible to illuminate the surface of the illumination device 1A entirely with brightness.

## Description

### Technical Field

The present invention relates to an illumination device for illuminating an operation unit for various types of electronic devices, and more particularly, to a thin illumination device capable of effectively utilizing the light emitted from a light source, and an input device equipped with the illumination device.

### Background Art

An electronic device of such type as audio equipment and a mobile electronic device is provided with a light guide member for guiding the light emitted from the light source such as the LED to the operation surface so as to illuminate the operation button, the fixed letter marked on the operation surface and the display unit having numbers displayed thereon.

Generally, the illumination device of the aforementioned type is structured to allow an illumination member such as an acrylic sheet attached to the back side of the operation surface of the electronic device to guide the light from the light source. This structure needs the space on the back side of the operation surface for accommodating the illumination member, which hinders the electronic device from having the thin structure.

Patent Document 1 discloses a laminated sheet for an optical element having an LED disposed in a recess portion formed in a bonding sheet 2 above the core material 1, and having the LED sealed with a transparent synthetic resin (light guide member).
Patent Document 1: Japanese Unexamined Patent Application Publication No. 2003-86847

### Disclosure of Invention

### Problem to be Solved by the Invention

In the generally employed illumination device as disclosed in Patent Document 1, the refractive index of the light guide member as an emission source is larger than that of an air layer as an emission target. The incident light at the incident angle smaller than the critical angle from those emitted from the light source such as the LED transmits the light guide member to be lost. In the generally employed illumination device, the incident light partially leaks without being reflected in the light guide member, resulting in the low light utilization efficiency. For this reason, the light source with unnecessarily large output has to be used, or the number of the light sources has to be increased.

With the generally employed illumination device, the area surrounding the light source is brightly illuminated. However, it is likely to become darker as the target is remote from the light source, resulting in the problem of the large illuminance difference.

The use of the generally employed illumination device may form island-like brighter spots (hot spot) on the surface of the light guide layer through scattering of the stray light, which may fail to uniformly illuminate the light guide layer surface.

It is an object of the present invention to provide an illumination device with the thin structure, and an input device equipped with the illumination device.

It is another object of the present invention to provide an illumination device capable of improving light utilization efficiency and supplying highly uniform bright illumination, and an input device equipped with the illumination device.

### Means for Solving the Problem

The present invention provides an illumination device which includes a substrate with a recess portion formed in a surface, a light emitting element installed in the recess portion, and a light guide layer laminated on a surface of the substrate. The light guide layer formed of a thin resin film and the surface of the substrate are fixed via an adhesive layer therebetween.

In the present invention, a resin film is used as the light guide layer, and the resin film is directly fixed to the substrate via the adhesive layer, thus simplifying and thinning the structure of the illumination device.

Preferably, an absolute refractive index of the adhesive layer is smaller than an absolute refractive index of the resin film.

In the structure, one surface (incident surface) of the resin film which forms the light guide layer is in contact with the adhesive layer, and the other surface is in contact with an air layer. Each absolute refractive index of the adhesive layer and the air layer is smaller than that of the resin film. So the resin film serves as a light guide path for propagating the light which fully reflects among the light rays passing therethrough.

Preferably, a sealant is filled in the recess portion to seal the light emitting element.

A bare chip 6 may be protected by the structure.

Preferably, a surface of the sealant is raised to have a convex shape, and a surface of the sealant and the light guide layer are bonded with the adhesive layer therebetween.

In the aforementioned structure, the incident angle at which the light output from the light source is irradiated to the interface between the adhesive layer and the light guide layer becomes small. The transmittance at the interface is improved so as to guide more light output from the light source to the light guide layer.

In the structure, a reflection recess portion is formed in the surface of the light guide layer opposite the light emitting element. The reflection recess portion is tapered from the surface to the inside of the light guide layer.

In the structure, the inclined surface of the reflection recess portion may be used as the reflection surface, thus guiding the light to the light guide layer efficiently.

For example, the reflection recess portion is in the form of an inclined surface which forms a V-like cross section, or a meniscus portion.

Preferably, a mirror member or a light absorbing member is disposed on the surface of the light guide layer at the position opposite at least the light emitting element.

When the mirror member is employed, the structure ensures to reflect the light that is about to transmit the light guide layer so as to be guided thereto. When the light absorbing member is employed, the structure is capable of preventing generation of the island-like hot spots.

Preferably, the mirror member includes a tapered reflection surface.

The structure allows the light to be propagated to the location far away from the light source.

Preferably, the resin film is transparent or semi-transparent. For example, the light guide layer may be formed by laminating a transparent resin film and a semi-transparent resin film.

The aforementioned structure allows the light to be scattered, resulting in the highly uniform illumination.

Preferably, the recess portion of the substrate is formed of a stepped portion having an opening area gradually increased from a deepest portion toward a surface of the recess portion.

The structure may increase the amount of light directly irradiated from the light source to the light guide layer. As the incident angle of the newly irradiated light is large, the light may be propagated to the location further away.

Preferably, the adhesive layer is not formed in a section opposite the light emitting element, and an air layer is formed in a section adjacent to the light guide layer and the light emitting element.

The structure is capable of propagating the light while being widely diffused, thus illuminating the entire light guide layer with sufficient brightness.

Preferably, an opening is formed in a surface of the substrate on which the light guide layer is laminated at the position opposite the recess portion by partially removing the light guide layer. A light guide member is formed inside the opening, having opposite upper and lower surfaces and a side surface interposed therebetween to form an outer circumferential portion. The lower surface is disposed opposite the light emitting element, and the inner surface of the opening is disposed opposite the side surface of the light guide member.

The structure takes the light emitted from the light emitting element from the lower surface of the light guide member so as to guide the light to the light guide layer via the side surface of the light guide member.

Preferably, the light guide member is formed by laminating a lower clad layer, a core layer and an upper clad layer from the bottom, and an absolute refractive index of the core layer is higher than each absolute refractive index of the lower and the upper clad layers.

The structure is capable of increasing the refraction angle upon incidence of the light to the light guide member to make sure to propagate the light to the location further away.

The present invention provides an input device using the illumination device as any one of those described above. The substrate includes a switch mechanism provided with a reversibly mounted metal reversing member and a counter electrode disposed opposite the reversing member. A surface of the reversing member is covered with the light guide layer.

The input device according to the present invention is capable of illuminating the switch mechanism using the illumination device. In the aforementioned structure, preferably, an optical element for scattering light or yielding a fluorescence is disposed in at least a portion of the light guide layer. For example, the optical element is any one of a scattering substance, a fluorescent substance and a prism.

The structure allows the use of various types of light to illuminate the switch mechanism.

Preferably, the optical element is disposed around the switch mechanism.

The structure is capable of illuminating the area around the switch mechanism without being illuminated directly. The same effect as the one derived from direct illumination of the switch mechanism may be obtained.

### Advantage of the Invention

The present invention is capable of preventing the light loss in the light guide member, resulting in the improved light utilization efficiency. The member to be illuminated (switch mechanism), thus may be illuminated more brightly. The present invention is capable of making manufacturing of the illumination device easier, and forming the thin structure.

### Best Mode for Carrying out the Invention

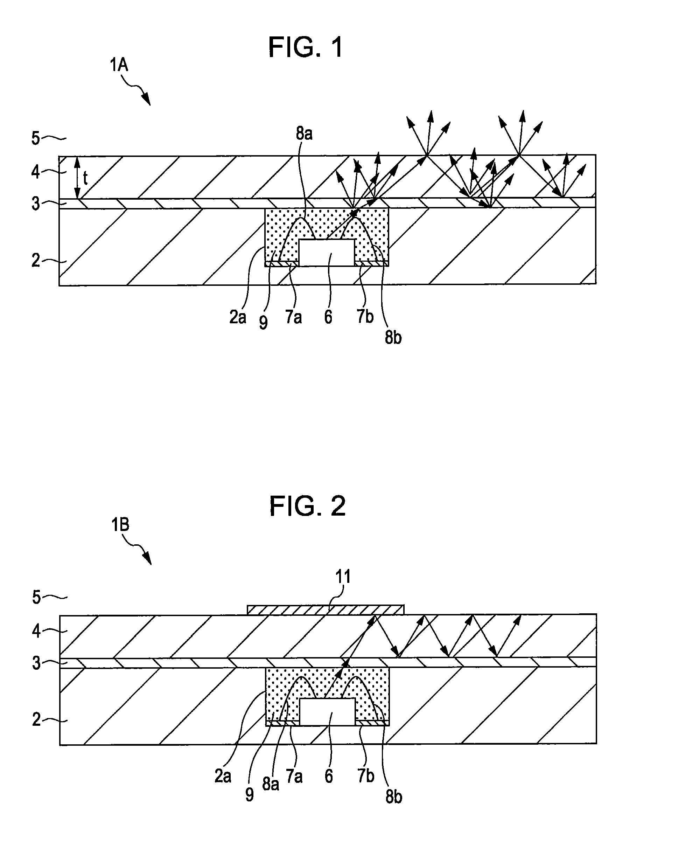

Fig. 1 is a sectional view of an illumination device according to a first embodiment of the present invention. Fig. 1 graphically shows the light passing in the light guide layer with an arrow mark, which applies to the subsequent embodiments.

Referring to Fig. 1, an illumination device 1A includes a substrate 2 which may be the synthetic resin substrate that does not substantially deflect, the film-like synthetic resin substrate that can easily deflect, or the metal substrate.

The substrate 2 has a recess portion 2a formed in the surface, and a bare chip (light source) 6 as an optical element accommodated to be fixed in the recess portion 2a with the adhesive agent. Electrode layers of the bare chip 6 are individually coupled (wire bonding) with conductive patterns 7a and 7b formed on the bottom of the recess portion 2a via thin conductive wires 8a and 8b, respectively. A sealant 9 formed of the clear synthetic resin is filled in the recess portion 2a so as to seal the bare chip 6 and the wires 8a, 8b with the resin therein. This makes it possible to protect the bare chip 6, and to further prevent the failure such as disconnection of the wires 8a and 8b.

The bare chip 6 may be structured to output the light in any color of red, green or blue. Alternatively, the light in other color, for example, white may be output. In case of the red light emission, the emission peak wavelength may be in the range from 610 to 740 nm. If the bare chip 6 is of the type for emitting green light, the emission peak wavelength may be in the range from 500 to 565 nm. If the bare chip 6 is of the type for emitting blue light, the emission peak wavelength may be in the range from 430 to 485 nm.

An adhesive layer 3 is formed on the surface of the substrate 2, and a light guide layer 4 is further formed on the adhesive layer 3. The surface of the light guide layer 4 is kept in contact with a space as an air layer 5.

The light guide layer 4 is formed of a thin film with a thickness preferably in the range from 10 to 100 µm, and more preferably in the range from 60 to 80 µm in consideration of the need for controlling the shape of the light guide layer and reducing the thickness. The light guide layer 4 is formed of a PET (polyethylene terephthalate) resin film, a PMMA (polymethylmethacrylate) resin film, a TAC (triacetylcellulose) resin film, an epoxy-based resin film with high refractive index, a silicone series resin film, and a translucent resin film such as a phenol-based resin film and an acrylic resin film. The light transmission rate of the aforementioned translucent resin film which forms the light guide layer 4 is 95% or higher. It can be said that the aforementioned film is substantially a transparent resin film.

The adhesive layer 3 is formed of a transparent acrylic adhesive agent or fluorine-contained epoxy-based adhesive agent.

Preferably, the absolute refractive index value of the sealant 9 is similar to that of the adhesive layer 3. The absolute refractive index value of the light guide layer 4 is higher than each value of the adhesive layer 3 and the air layer 5. The absolute refractive index of the adhesive layer 3 is higher than that of air. Most of the light emitted from the bare chip 6 transmits the sealant 9 and the adhesive layer 3 to be guided to the light guide layer 4. A portion of the aforementioned light passes in the light guide layer 4 while fully reflecting on the boundary surface between the light guide layer 4 and the adhesive layer 3, and the boundary surface between the light guide layer 4 and the air layer 5. The portion of the light which does not fully reflect leaks outside from the surface of the transparent resin film that forms the light guide layer 4. Accordingly, the illumination device 1A serves as the surface-emitting structure.

The illumination device 1A of the first embodiment employs the thin transparent resin film for forming the light guide layer 4 so as to be bonded to the substrate 2 via the thin adhesive layer 3, thus simplifying the manufacturing process and reducing the thickness of the entire structure.

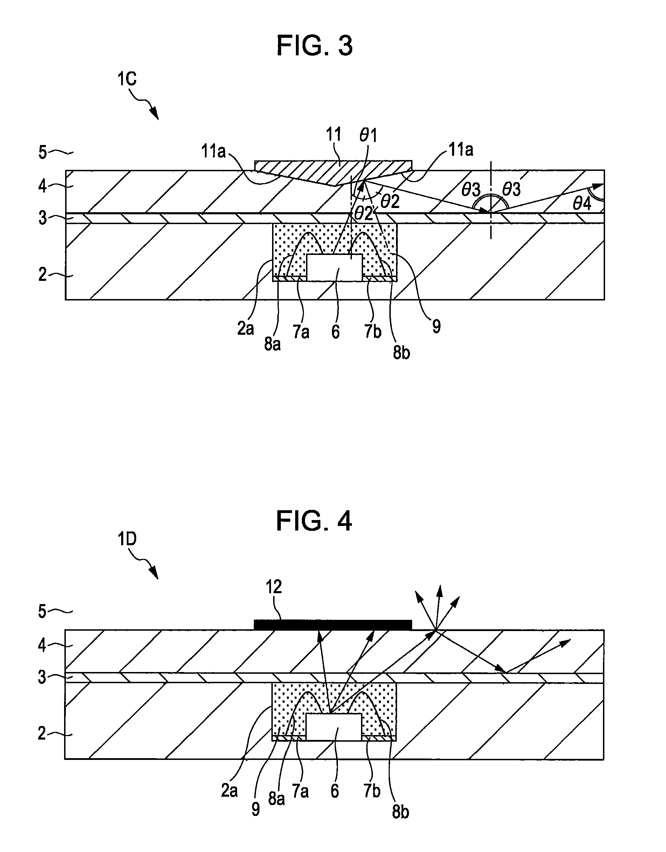

Fig. 2 is a sectional view of an illumination device according to a second embodiment of the present invention. Fig. 3 is a sectional view of a modified example of the second embodiment. Hereinafter, the same components as those described in the above embodiments will be designated with the same reference numerals.

An illumination device 1 B according to the second embodiment shown in Fig. 2 has substantially the same structure as that of the illumination device 1A according to the first embodiment except that a mirror member 11 is disposed on the surface of the light guide layer 4 above the recess portion 1a at the position opposite the bare chip 6.

In the embodiment, of the light directly irradiated into the light guide layer 4 from the bare chip 6, the light which has transmitted through the light guide layer 4 via the position above the recess portion 1a reflects on the mirror member 11 so as to be returned into the light guide layer 4. The structure of the embodiment prevents leakage of the light irradiated to the boundary surface between the light guide layer 4 and the air layer 5 at the incident angle smaller than the critical angle, which is supposed to leak out of the light guide layer 4. Of the light directly irradiated into the light guide layer 4 from the bare chip 6, the amount of the light that directly leaks outside the light guide layer 4 above the recess portion 1a without reflection may be suppressed. This makes it possible to increase the amount of the light propagated through the light guide layer 4, and to irradiate more light to the location further away from the bare chip 6. In the illumination device 1A according to the first embodiment, the center region opposite the bare chip 6 is illuminated with the highest luminance, and the luminance is gradually lost as the light is directed to the circumferential location far away from the bare chip 6, resulting in large difference in the light intensity between the center and the circumferential location.

The illumination device 1 B of the second embodiment prevents the leakage of the light at the center opposite the bare chip 6, which allows more light to be guided to the circumferential location. Accordingly, the difference in the light intensity between the center and the circumferential location may be reduced. That is, the illumination device 1 B may be of surface-emitting type for uniform emission.

An illumination device 1C shown in Fig. 3 as the modified example of the second embodiment shown in Fig. 2 has the similar structure to the illumination device 1 B except that the lower surface (reflection surface) of the mirror member 11 has tapered surfaces 11a, 11a. That is, the reflection surfaces 11a form an inverted cone shape, or an inverted pyramid shape having the center with the largest thickness and the peripheral sections each having the thickness gradually decreased as it is remote from the center.

In the modified example shown in Fig. 3, of the light irradiated directly from the bare chip 6 into the light guide layer 4, the light irradiated at the small incident angle θ1 with respect to the axis perpendicular to the boundary surface between the adhesive layer 3 and the light guide layer 4 is allowed to reflect on the reflection surface 11a at the large reflection angle θ2. This makes it possible to increase the angle (reflection angle θ3 at the boundary surface with the adhesive agent 3, and the reflection angle θ4 at the boundary surface between the light guide layer 4 and the air layer 5) at which the light reflects in the light guide layer 4 subsequently. This makes it possible to propagate the light from the bare chip 6 at the center to the remote location. The illumination device 1C provides the wide emission area.

Fig. 4 is a sectional view of an illumination device according to a third embodiment of the present invention.

An illumination device 1 D shown in Fig. 4 has substantially the same structure as that of the illumination device according to the second embodiment except that a light absorbing member 12 is disposed on the surface of the light guide layer 4 above the position opposite the recess portion 2a or the bare chip 6 instead of the mirror member 11.

The light absorbing member 12 may be formed as a black layer with uniformity. In this case, however, a large amount of light is absorbed, which may require more outputs of the light source (bare chip 6) for providing sufficient light to serve as the illumination device, thus deteriorating the efficiency. It is preferable to form the black dot pattern or black matrix pattern on the light absorbing member 12 so as to allow a part of the light to transmit therethrough. Such member may be obtained by forming a metal chrome film on the glass substrate through spattering to be finished into the dot or the matrix pattern through the photolithography. Alternatively, the thin metal film (chrome, nickel, aluminum in the form of an elementary substance, an alloy or an oxide) is deposited or spattered on the surface of the light guide layer at the air side using the same principle as the case of ND filter to allow the part of the light to absorb or reflect, and the rest of the light to transmit. The thus formed light absorbing member 12 is fixed on the surface of the light guide layer 4 above the recess portion 2a.

In the embodiment, of the light irradiated into the light guide layer 4 from the bare chip 6, the light scattered on the concavo-convex surfaces of the adhesive layer 3 and the concavo-convex upper and lower surfaces of the light guide layer 4 on the transmission path may be absorbed by the light absorbing member 12. This makes it possible to suppress generation of the island-like pattern of the plural brighter spots (hot spot) caused by scattering of stray light, which may enevenly illuminate the surface of the light guide layer 4.

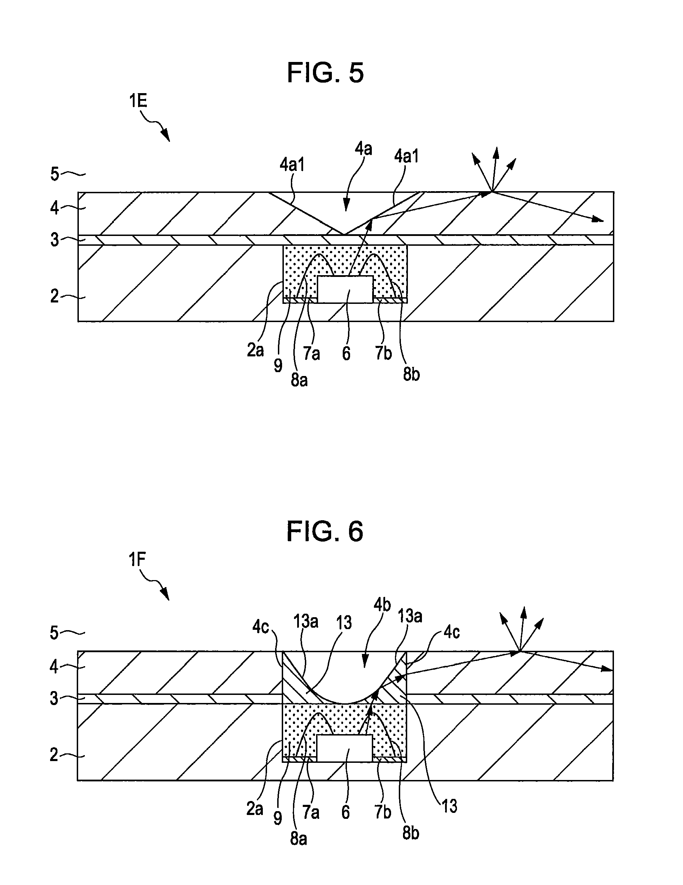

Fig. 5 is a sectional view of an illumination device according to a fourth embodiment of the present invention.

An illumination device 1 E shown in Fig. 5 has substantially the same structure as that of the illumination device of the first embodiment except that a reflection recess portion 4a is formed in the surface of the light guide layer 4 at the position opposite the recess portion 2a or the bare chip 6, which is tapered from the surface inward.

The reflection recess portion 4a has a substantially V-like cross section which allows inclined surfaces 4a1 forming the V-shape to serve as the reflection mirror. The illumination device 1 E according to the fourth embodiment is capable of guiding the light directly irradiated to the light guide layer 4 from the bare chip 6 into the light guide layer 4 by the reflection on the inclined surface 4a1. Unlike the case without the reflection recess portion 4a where a part of the light directly irradiated from the bare chip 6 to the light guide layer 4 transmits therethrough to be lost, the embodiment is capable of preventing the aforementioned leakage of the light. Likewise the fourth embodiment, the incident angle of the light at the subsequent reflection in the light guide layer 4 (reflection angle on the boundary surface between the light guide layer 4 and the adhesive layer 3, and the reflection angle on the boundary surface between the light guide layer 4 and the air layer 5) may be increased. This makes it possible to propagate the light to the location further away from the bare chip 6. The illumination device 1 E with a wide emission range may be provided.

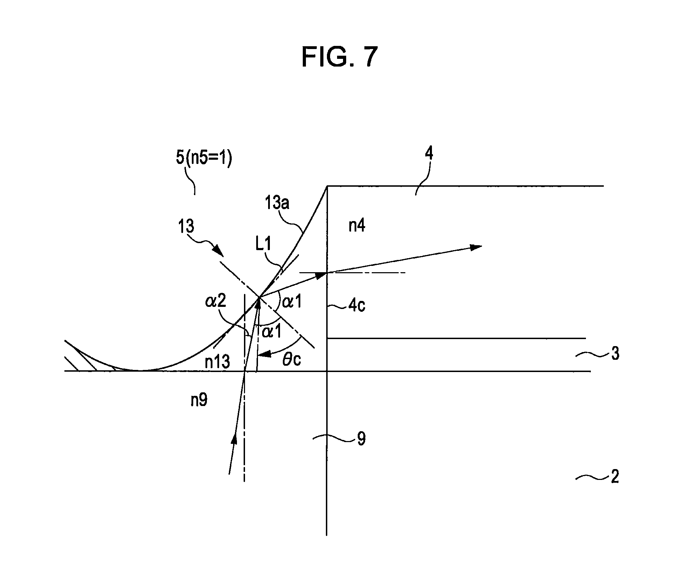

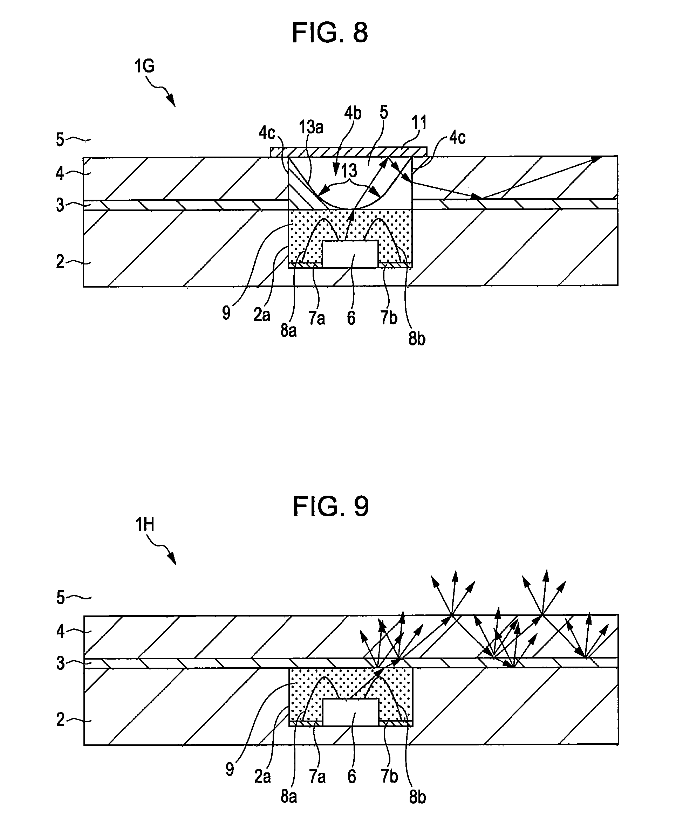

Fig. 6 is a sectional view of an illumination device according to a fourth embodiment of the present invention. Fig. 7 is an enlarged sectional view representing a portion of the illumination device shown in Fig. 6. Fig. 8 is a sectional view showing a modified example of the illumination device of the fourth embodiment.

In the fourth embodiment shown in Fig. 6, the portion of the light guide layer 4, which is opposite the recess portion 2a has an opening 4b, an inner surface 4c of which is provided with a meniscus portion (reflection recess portion) 13 as a quadratic function curve having a concave cross section.

The meniscus portion 13 is formed in the illumination device 1A (see Fig. 1) having the light guide layer 4 formed of the resin film bonded onto the substrate 2 via the adhesive layer 3. That is, the opening 4b is formed by removing the light guide layer 4 and the adhesive layer 3 for forming the circular part in the exposure/development process. When a small amount of the liquid synthetic resin in the molten state is poured into the opening 4b, the circumferential portion of the liquid synthetic resin is raised at the level higher than the center through the capillary phenomenon. In the aforementioned state, the liquid synthetic resin is cured to form the meniscus portion 13.

The light irradiated from the bare chip 6 refracts on the boundary between the sealant 9 and the meniscus portion 13, reflects on the boundary surface between a recess surface 13a of the meniscus portion 13 and the air layer 5, and further refracts on the boundary between the meniscus portion 13 and the inner surface 4c of the light guide layer 4 so as to be guided into the light guide layer 4. This makes it possible to guide more light to the light guide layer 4.

Preferably, the full reflection on the boundary surface between the recess surface 13a of the meniscus portion 13 and the air layer 5 reduces the amount of light that transmits from the recess surface 13a to the air layer 5. As the enlarged view of Fig. 7 shows, it is preferable to set an incident angle α1 with respect to the axis perpendicular to the boundary surface (tangential line) L1 between the recess surface 13a of the meniscus portion 13 and the air layer 5 to be equal to or larger than the critical angle θc with respect to the boundary surface L1. Preferably, the synthetic resin for forming the meniscus portion 13 has the absolute refractive index n13 equal to or smaller than the absolute refractive index n9 of the resin for forming the sealant 9 such that the refraction angle α2 of the light irradiated from the sealant 9 to the meniscus portion 13 becomes large.

Preferably, a large amount of light passes without fully reflecting on the boundary between the meniscus portion 13 and the inner surface 4C of the light guide layer 4. It is preferable to set the absolute refractive index n13 of the synthetic resin for forming the meniscus portion 13 to be equal to or smaller than the absolute refractive index n4 of the resin film for forming the light guide layer 4. Preferably, the absolute refractive index values of n9, n13 and n4 of the synthetic resins for forming the sealant 9 and the meniscus portion 13, and the resin film for forming the light guide layer 4 establish the relation of n13≤n9≤n4.

An illumination device 1F according to the fourth embodiment reflects the light irradiated to the recess surface 13a of the meniscus portion 13 so as to be guided into the light guide layer 4 via the inner surface 4c thereof. However, it is difficult to guide the light irradiated to the area around the bottom of the recess surface 13a into the light guide layer 4.

An illumination device 1G as a modified example shown in Fig. 8 is formed by providing the mirror member 11 on the surface of the light guide layer 4 right above the opening 4b having the meniscus portion 13 of the illumination device 1F shown in Fig. 6.

In the illumination device 1G, the incident light at the area around the bottom of the recess surface 13a of the meniscus portion 13 transmits inside the opening 4b to reflect on the mirror member 11 so as to be guided to the inner surface 4c of the light guide layer 4. Likewise the illumination device 1B (see Fig. 2) according to the second embodiment, the illumination device ensures to guide the light reflecting on the mirror member 11 into the light guide layer 4.

The mirror member 11 may have tapered reflection surfaces 11a, 11a likewise the one described as the modified example of the second embodiment (see Fig. 3). Besides the mirror member 11, the light absorbing member 12 shown in the illumination device 1 D (see Fig. 4) according to the third embodiment may be employed to suppress generation of the hot spot on the surface of the light guide layer 4.

Fig. 9 is a sectional view of an illumination device according to a fifth embodiment of the present invention.

In an illumination device 1 H shown in Fig. 9, the filler is mixed with the inside of the transparent resin for forming the light guide layer 4 to form a light scattering layer for diffusely reflecting the light therein. The filler may be formed as white inorganic oxide powder, metal powder and the like. The resin film is semi-transparent. The filler may be mixed with the adhesive agent for forming the adhesive layer 3 instead of mixing the filler with the light guide layer 4 so as to form the semi-transparent adhesive layer 3 as the light scattering layer.

The resin film (light scattering layer) formed by mixing the filler may be laminated on at least one of the upper and the lower surfaces of the transparent resin film to form the light guide layer 4.

The illumination device 1 H according to the fifth embodiment is capable of enhancing the optical diffusion in the light scattering layer which contains the filler, resulting in the uniform illumination with less unevenness.

The structure according to the first to the fourth embodiments may include the light guide layer 4 as described in the fifth embodiment instead of the transparent light guide layer 4.

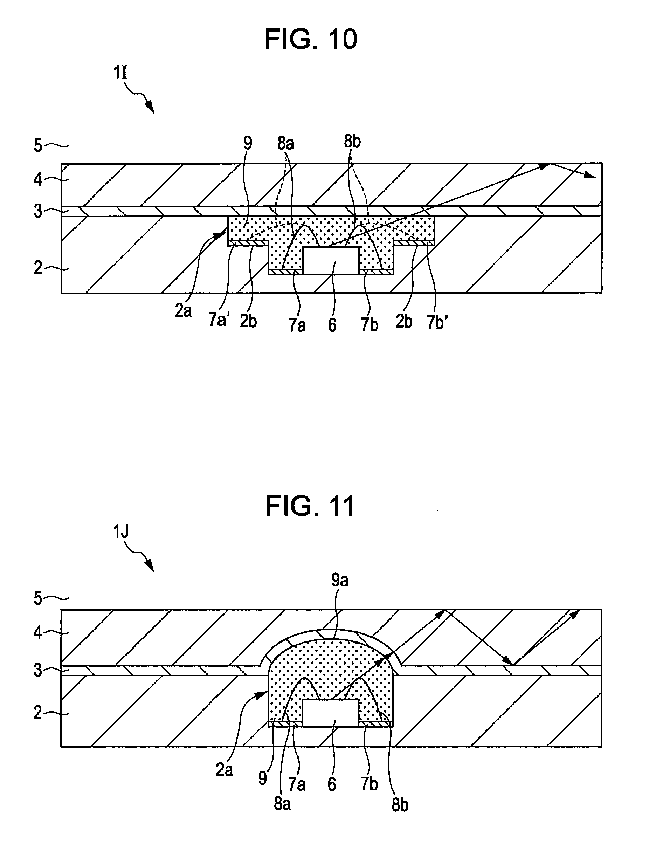

Fig. 10 is a sectional view of an illumination device according to a sixth embodiment of the present invention.

In the case of the illumination device 1A according to the first embodiment, of the light radially irradiated from the bare chip (light emitting element) 6, the light directed to the side is reflected on the side wall of the recess portion 2a to reach the light guide layer 4 owing to the narrow opening area of the recess portion 2a. Such light becomes the stray light which may cause the hot spot.

An illumination device 1I as the sixth embodiment includes plural stepped portions having the opening area gradually widened from the deepest position to the upper surface. The illumination device 1I according to the sixth embodiment may increase the amount of the light directly guided from the bare chip (light emitting element) 6 into the light guide layer 4. This may prevent generation of the hot spot, thus allowing the surface of the light guide layer 4 to be uniformly illuminated. The recess portion 2a with the plural stepped portions is applicable to the other embodiments.

As a dotted line in Fig. 10 shows, the wires 8a, 8b may be wire bonded to the conductive patterns 7a, 7b formed on the bottom of the recess portion 2a, or may be wire bonded to conductive patterns 7a', 7b' formed on the respective stepped portions 2b, 2b.

Fig. 11 is a sectional view of an illumination device according to a seventh embodiment of the present invention.

An illumination device 1J according to the seventh embodiment shown in Fig. 11 includes a raised sealant 9 for sealing the bare chip 6 in the recess portion 2a, having a surface 9a formed into a convex shape, preferably, a spherical surface. The resin film for forming the light guide layer 4 may be formed of a transparent material or a semi-transparent material which contains a light diffusion layer, and is adhered and fixed to the surface 9a of the raised sealant 9 and the surface of the substrate 2 via the adhesive layer 3.

In the illumination device 1J according to the seventh embodiment, the surface 9a of the sealant 9 has the convex shape, and accordingly, the interface between the adhesive layer 3 and the light guide layer 4 for covering the surface has the convex shape. Then the incident angle of the light output from the light source (bare chip 6) into the interface between the adhesive layer 3 and the light guide layer 4 becomes smaller than the incident angle of the light into the interface with the shape other than the convex (for example, flat or concave shape). This may improve the transmittance to allow more light output from the bare chip 6 to be guided to the light guide layer 4. Especially when the sealant 9 has substantially the same absolute refractive index as that of the adhesive layer 3, the reflection of the light on the interface between the sealant 9 and the adhesive layer 3 may be suppressed. This makes it possible to transmit most of the light directed from the sealant 9 to the adhesive layer 3, thus enhancing the light utilization efficiency. That is, the illumination device 1J is capable of performing brighter illumination.

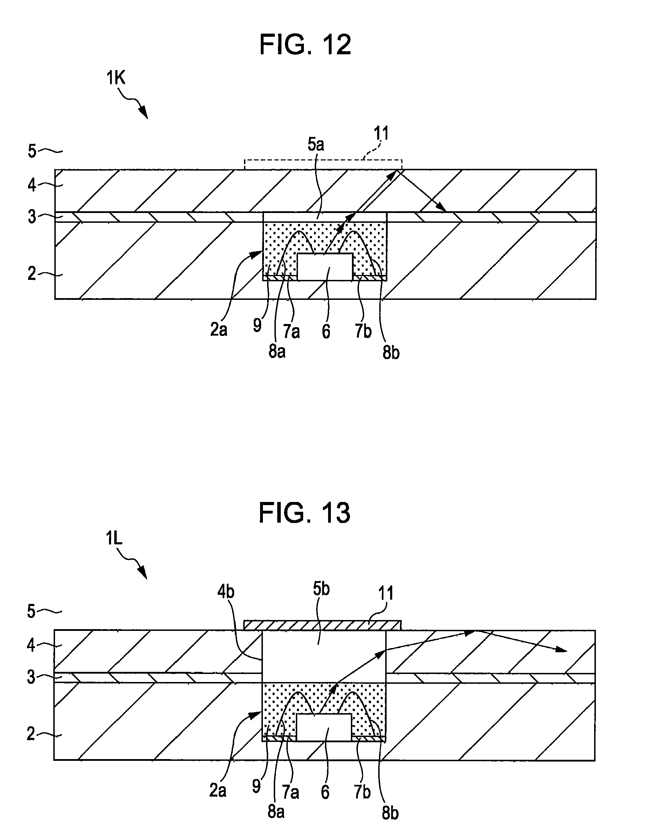

Fig. 12 is a sectional view of an illumination device according to an eighth embodiment of the present invention. Fig. 13 is a sectional view of an illumination device as a modified example of the eighth embodiment.

Referring to Fig. 12, an illumination device 1K according to the eighth embodiment has a portion of the adhesive layer 3 opposite the recess portion 2a and positioned between the upper surface of the sealant 9 and the lower surface of the light guide layer 4 removed, or the adhesive layer 3 is not formed at the section expected to form the air layer 5a beforehand. In the illumination device 1K, the light emitted from the bare chip 6 transmits from the sealant 9 to pass the air layer 5a so as to be guided to the light guide layer 4. Referring to Fig. 12, the illumination device may be provided with the flat mirror member 11 as described above, and the mirror member 11 with the tapered reflection surface 11a on the surface of the light guide layer 4 opposite the recess portion 2a as indicated by the dotted line.

An illumination device 1L as a modified example of the eighth embodiment includes an opening 4b to form an air layer 5b by eliminating the adhesive layer 3 and the light guide layer 4 opposite the recess portion 2a, or preventing formation of the adhesive layer 3 and the light guide layer 4 in the corresponding section. The mirror member 11 is disposed above the opening 4b to close the air layer 5b. The mirror member 11 may be provided with a tapered reflection surface 11a (see Fig. 3). In the illumination device 1J, the light emitted from the bare chip 6 passes from the sealant 9 to the air layer 5b so as to be guided into the light guide layer 4. Alternatively, the light reflects on the mirror member 11 once, and then is guided into the light guide layer 4.

In the eighth embodiment shown in Fig. 12 and the modified example shown in Fig. 13, the light advances along the path from the light source (bare chip 6), the sealant 9, the air layer 5a or 5b, the light guide layer 4 to the air layer 5 sequentially. The section with different absolute refractive index is provided on the path where the light passes before it leaks out (air layer 5) of the light guide layer 4 so as to propagate the light while being widely diffused. This makes it possible to illuminate the entire light guide layer 4 brightly.

The light guide layer 4 in the eighth embodiment and the modified example may be the transparent resin film, or the semi-transparent resin film.

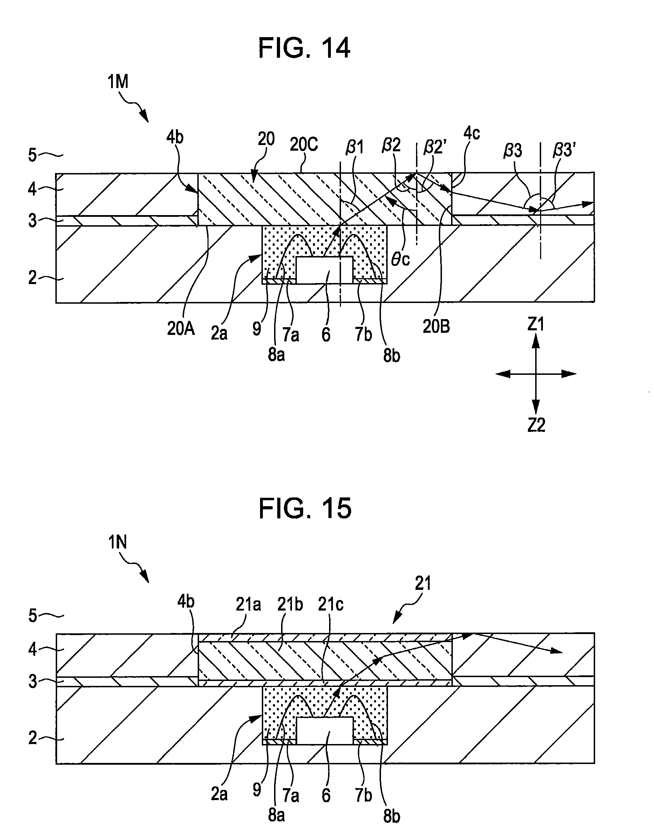

Fig. 14 is a sectional view of an illumination device according to a ninth embodiment. Fig. 15 is a sectional view of an illumination device as a modified example of the ninth embodiment.

An illumination device 1M according to the ninth embodiment shown in Fig. 14 includes an opening 4b above the recess portion 2a, and a light guide member 20 in the opening 4b. The light guide member 20 includes an incident surface 20A to which the light is irradiated from the bare chip 6 as shown in the lower surface of the drawing (surface at Z2 side shown in Fig. 14), and an ejection surface (side surface) 20B on the outer circumference (side direction) of the region between the upper and the lower surfaces, from where the incident light ejects toward the light guide layer 4. The lower surface of the light guide member 20 is directed opposite the bare chip 6, and the ejection surface (side surface) 20B of the light guide member 20 is directed opposite the inner surface 4c of the light guide layer.

The single transparent or semi-transparent light guide resin layer may be employed for forming the light guide member 20. Alternatively, plural light guide resin layers each with different absolute refractive index may be laminated to form the single light guide member 20.

In the embodiment, a refraction angle β1 at which the light transmitted through the sealant 9 from the bare chip 6 and irradiated to an incident surface (lower surface) 20A of the light guide member 20 becomes large. An incident angle β2 with respect to the boundary surface between the light guide member 20 and the air layer 5 may be made larger than a critical angle θc between the aforementioned angles to allow the full reflection. The amount of light which leaks from the upper surface 20C of the light guide member 20 above the recess portion 2a or right above the bare chip 6 may be reduced. The amount of light which transmits from an ejection surface 20B as the side surface of the light guide member 20 to the inner surface 4c of the light guide layer 4 may be increased.

The incident angle β2 at the boundary surface between the light guide member 20 and the air layer 5, and a reflection angle β2' thereof may be increased. Likewise, the incident angle β3 at the boundary surface between the light guide layer 4 and the adhesive layer 3, and a reflection angle β3' thereof may be increased. This makes it possible to propagate the light which passes inside the light guide layer 4 to the further location.

In the case where the light guide member 20 formed by laminating plural light guide resin layers, it is preferable to laminate those layers to have the absolute refractive index values gradually increased from the lower surface (surface at the Z2 side) to the upper surface (surface at the Z1 side) of the light guide member 20. The refraction angles of the respective light guide resin layers may be gradually decreased such that the incident angle β2 of the light directed to the boundary surface between the light guide member 20 and the air layer 5 is made larger than the critical angle θc on the boundary surface.

In an illumination device 1 N as the modified example shown in Fig. 15, the light guide member 21 is formed as a three-layer structure including an upper clad layer 21a, a core layer 21b and a lower clad layer 21 c. The lower clad layer 21c may be designed to serve as the adhesive layer.

The absolute refractive index of the core layer 21b for forming the light guide member 21 is higher than each absolute refractive index of the upper clad layer 21a and the lower clad layer 21c. The light passing inside the core layer 21 b enters into the respective boundary surfaces between the core layer 21b and the upper/lower clad layers 21a, 21c at the incident angle equal to or larger than the critical angle. The light is, thus, allowed to advance farther away while being fully reflected on the boundary surface.

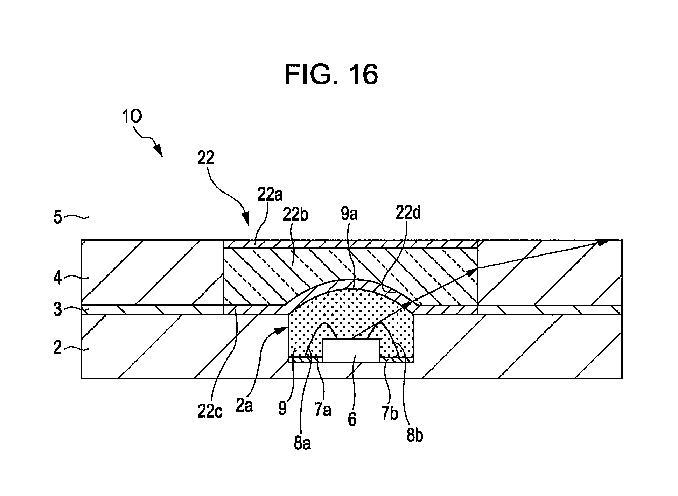

Fig. 16 is a sectional view of an illumination device according to a tenth embodiment of the present invention.

In an illumination device 1O according to the tenth embodiment, the surface 9a of the sealant 9 inside the recess portion 2a is formed into a convex shape, more preferably, a spherical shape, and a light guide member 22 is provided above the surface 9a. That is, a concave surface 22d corresponding to the surface 9a is formed in the lower surface of the core layer 22b for forming the light guide member 22, and the space between the concave curved surface 22d and the surface 9a of the sealant 9 is fixed with the lower clad layer 22c serving as the adhesive layer. Likewise the aforementioned structure, respective values of the absolute refractive index of the upper clad layer 22a and the lower clad layer 22c are smaller than the refractive index of the core layer 22b.

In the embodiment, the incident angle of the light output from the light source into the surface 9a of the sealant 9 becomes small. Likewise the seventh embodiment shown in Fig. 11, most of the light output from the bare chip 6 may be guided to the light guide layer 4. Likewise the modified example of the ninth embodiment shown in Fig. 15, the light passing inside the light guide layer 4 is allowed to advance farther away while being fully reflected on the boundary surface.

An example using any one of the above-described illumination devices will be described.

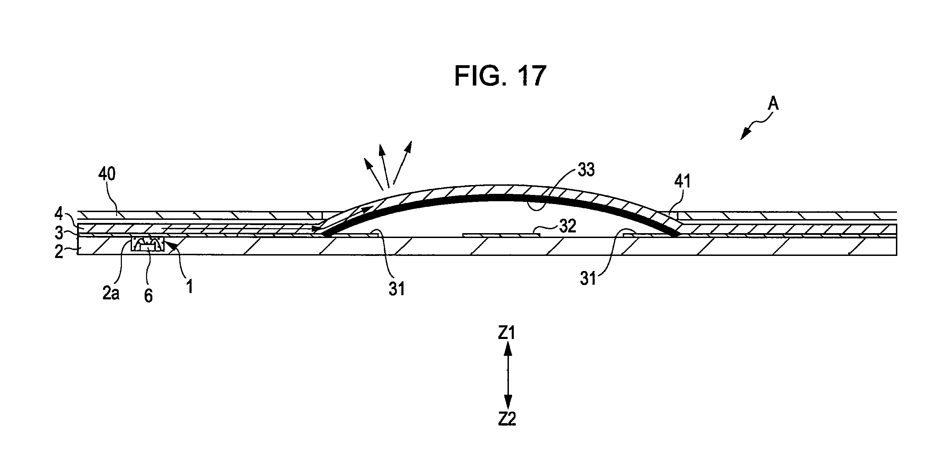

Each of Figs. 17 to 19 is a sectional view showing a portion of an input device installed in a mobile terminal device as an example which employs the illumination device. Each of input devices A to C shown in Figs. 17 to 19 includes a metal dome switch (switch mechanism) 30 and any one of the above-described illumination devices 1.

In each of the input devices A to C, a ring-shaped connector electrode 31 is formed on the surface of the substrate 2, and a counter electrode 32 separated from the connector electrode 31 is formed on the center thereof. A reversing member 33 formed of a dome-like metal plate is provided. A proximal end of the reversing member 33 at the circumferential side is conductive connected to the surface of the connector electrode 31. When the pressure force in the direction Z2 shown in the drawing is applied to the surface of the reversing member 33, the reversing member 33 deforms to bring the metal plate at its back side into contact with the counter electrode 32. As a result, the connector electrode 31 and the counter electrode 32 are conductive connected via the reversing member 33. That is, the connector electrode 31, the counter electrode 32 and the reversing member 33 form the metal dome switch (switch mechanism) 30 which is capable of switching ON/OFF between the connector electrode 31 and the counter electrode 32 based on the pressurized state.

In each of the input devices A to C, the light guide layer 4 as the transparent or the semi-transparent resin film is laminated on the surfaces of the substrate 2 and the reversing member 33. The light guide layer 4 is tightly fixed to the surfaces of the substrate 2 and the reversing member 33 via the adhesive layer 3 therebetween. A light emitting element as the bare chip 6 is buried in the recess portion 2a of the substrate 2, around which is filled with the sealant 9.

The upper portion of the light guide layer 4 is covered with a casing 40 for forming an outer case of the mobile terminal device. The dome-like reversing member 33 is exposed outside through an opening 41 formed in the casing 40. The light which has leaked from the light guide layer 4 never leaks outside the casing 40 from the area other than the opening 41.

In the input device A as the first example shown in Fig. 17, the light emitted from the bare chip 6 passes inside the light guide layer 4 while fully reflecting. The light propagating in the light guide layer 4 impinges against the proximal end of the reversing member 33 to have the direction changed to the one along the dome shape for forming the reversing member 33. At this time, reflection and scattering of the light occurs around the proximal end. As a result, the amount of light which leaks from the region around the proximal end of the reversing member 33 to the outside the light guide layer 4 is increased. The resultant light leaks out of the casing 40 via the opening 41. This makes it possible to illuminate the region around the proximal end of the reversing member 33 brighter than any other region.

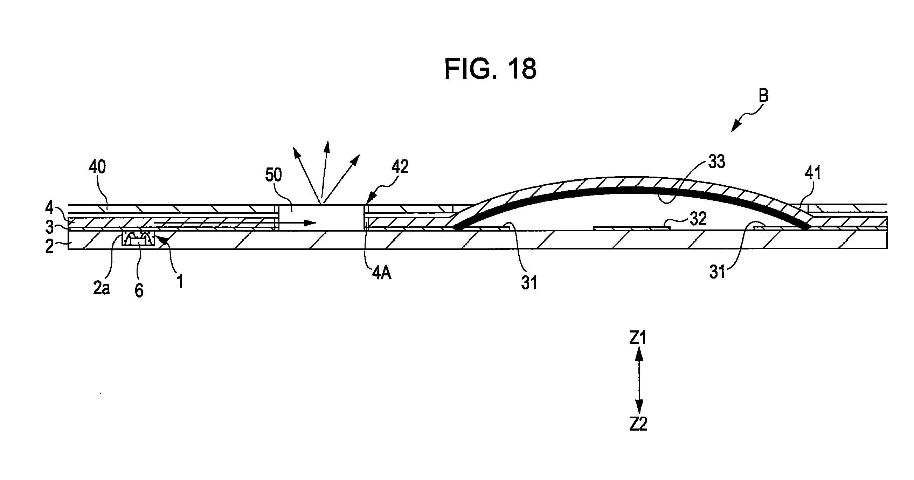

In the input device B as the second example shown in Fig. 18, an optical element 50 formed of a scattering substance or fluorescent substance is disposed around the metal dome switch 30. The optical element 50 is fixed onto the substrate 2, and exposed outside the casing 40 through a hole 42 formed in the casing 40 around the metal dome switch 30. The optical elements 50 may be distributed around the metal dome switch 30.

The optical element 50 is disposed opposite the inner surface of a mount hole 4A formed in the light guide layer 4. The light propagating inside the light guide layer 4 leaks from the inner surface of the mount hole 4A so as to be irradiated to the optical element 50. In the optical element 50, light scattering occurs in the scattering substance, or the specific wavelength of the light irradiated from the light guide layer 4 is absorbed by the fluorescent substance so as to yield a fluorescence to generate the visible light. The region around the metal dome switch 30, thus, may be brightly illuminated.

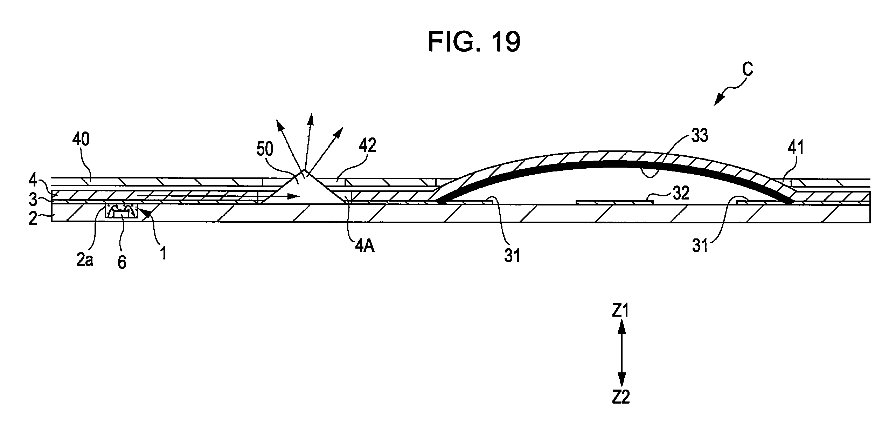

In the input device C as the third example shown in Fig. 19, a triangular prism is disposed as the optical element 50 instead of the scattering substance or the fluorescent substance as described in the second example. In the example, the light leaking from the inner surface of the mount hole 4A is irradiated to the triangular prism to scatter the light. The triangular prism is formed of the transparent resin, and the filler is mixed with the inside portion of the resin so as to form the optical element for facilitating the diffused reflection of the light inside.

In the first to the third examples, the use of the illumination device 1 according to the present invention allows the metal dome switch 30 installed in any of the input devices A to C of the mobile terminal device and the circumference thereof to be brightly illuminated. This makes it possible to improve the operability of the mobile terminal device.

In the aforementioned examples, the optical element 50 is disposed opposite the inner surface of the mount hole 4A formed in the light guide layer 4. However, the present invention is not limited to the structure as described above. For example, the optical element 50 may have its bottom (incident surface) fixed while being directed to the surface of the light guide layer 4 so as to scatter or yield the fluorescence with respect to the light leaking from the surface of the light guide layer 4.

### Brief Description of the Drawings

[Fig. 1] Fig. 1 is a sectional view of an illumination device according to a first embodiment of the present invention.
[Fig. 2] Fig. 2 is a sectional view of an illumination device according to a second embodiment of the present invention.
[Fig. 3] Fig. 3 is a sectional view of a modified example of the second embodiment.
[Fig. 4] Fig. 4 is a sectional view of an illumination device according to a third embodiment of the present invention.
[Fig. 5] Fig. 5 is a sectional view of an illumination device according to a fourth embodiment of the present invention.
[Fig. 6] Fig. 6 is a sectional view of an illumination device according to the fourth embodiment of the present invention.
[Fig. 7] Fig. 7 is a sectional view showing an enlarged portion of the structure shown in Fig. 6.
[Fig. 8] Fig. 8 is a sectional view showing a modified example of the fourth embodiment.
[Fig. 9] Fig. 9 is a sectional view of an illumination device according to a fifth embodiment of the present invention.
[Fig. 10] Fig. 10 is a sectional view showing an illumination device according to a sixth embodiment of the present invention.
[Fig. 11] Fig. 11 is a sectional view showing an illumination device according to a seventh embodiment of the present invention.
[Fig. 12] Fig. 12 is a sectional view of an illumination device according to an eighth embodiment of the present invention.
[Fig. 13] Fig. 13 is a sectional view showing an illumination device as a modified example of the eighth embodiment.
[Fig. 14] Fig. 14 is a sectional view showing an illumination device according to a ninth embodiment of the present invention.
[Fig. 15] Fig. 15 is a sectional view of an illumination device as a modified example of the ninth embodiment.
[Fig. 16] Fig. 16 is a sectional view of an illumination device according to a tenth embodiment of the present invention.
[Fig. 17] Fig. 17 is a partially sectional view showing an input device installed in a mobile terminal device as a first example using the illumination device.
[Fig. 18] Fig. 18 is a partially sectional view showing an input device installed in the mobile terminal device as a second example using the illumination device.
[Fig. 19] Fig. 19 is a partially sectional view showing an input device installed in the mobile terminal device as a third example using the illumination device.

### Reference Numerals

- 1,1A- 1O: illumination device
- 2: substrate
- 2a: recess portion
- 3: adhesive layer
- 4: light guide layer
- 4a: reflection recess portion
- 5: air layer
- 6: bare chip (light emitting element)
- 7a,7b: conductive pattern
- 8a,8b: wire
- 9: sealant
- 9a: surface of sealant
- 11: mirror member
- 11a: tapered reflection surface
- 12: light absorbing substance
- 13: meniscus portion (reflection recess portion)
- 13a: recess surface of the meniscus portion
- 20, 21, 22: light guide member
- 21a,22a: upper clad layer
- 21b,22b: core layer
- 21c,22c: lower clad layer
- 22d: concave surface
- 30: metal dome switch (switch mechanism)
- 31: connector electrode
- 32: counter electrode
- 30: reversing member
- 40: casing
- 41: opening
- 42: hole
- 50: optical element
- A,B,C: input device

## Claims

1. An illumination device comprising a substrate with a recess portion formed in a surface, a light emitting element installed in the recess portion, and a light guide layer laminated on a surface of the substrate, wherein the light guide layer is formed of a thin resin film, and the resin film and the surface of the substrate are fixed via an adhesive layer therebetween.

2. The illumination device according to Claim 1, wherein an absolute refractive index of the adhesive layer is smaller than an absolute refractive index of the resin film.

3. The illumination device according to Claim 1, wherein a sealant is filled in the recess portion to seal the light emitting element.

4. The illumination device according to Claim 3, wherein a surface of the sealant is raised to have a convex shape, and a surface of the sealant and the light guide layer are bonded with the adhesive layer therebetween.

5. The illumination device according to Claim 1, wherein a reflection recess portion is formed in the surface of the light guide layer opposite the light emitting element, and the reflection recess portion is tapered from the surface to the inside of the light guide layer.

6. The illumination device according to Claim 5, wherein the reflection recess portion is in the form of an inclined surface which forms a V-like cross section, or a meniscus portion.

7. The illumination device according to Claim 1, wherein a mirror member or a light absorbing member is disposed on the surface of the light guide layer at the position opposite at least the light emitting element.

8. The illumination device according to Claim 7, wherein the mirror member includes a tapered reflection surface.

9. The illumination device according to Claim 1, wherein the resin film is transparent or semi-transparent.

10. The illumination device according to Claim 1, wherein the light guide layer is formed by laminating a transparent resin film and a semi-transparent resin film.

11. The illumination device according to Claim 1, wherein the recess portion of the substrate is formed of a stepped portion having an opening area gradually increased from a deepest portion toward a surface of the recess portion.

12. The illumination device according to Claim 1, wherein the adhesive layer is not formed in a section opposite the light emitting element, and an air layer is formed in a section adjacent to the light guide layer and the light emitting element.

13. The illumination device according to Claim 1, wherein:
an opening is formed in a surface of the substrate on which the light guide layer is laminated at the position opposite the recess portion by partially removing the light guide layer;
a light guide member is formed inside the opening, having opposite upper and lower surfaces and a side surface interposed therebetween to form an outer circumferential portion; and
the lower surface is disposed opposite the light emitting element, and the inner surface of the opening is disposed opposite the side surface of the light guide member.

14. The illumination device according to Claim 13, wherein:
the light guide member is formed by laminating a lower clad layer, a core layer and an upper clad layer from the bottom; and
an absolute refractive index of the core layer is higher than each absolute refractive index of the lower and the upper clad layers.

15. An input device using the illumination device according to Claim 1, wherein:
the substrate includes a switch mechanism provided with a reversibly mounted metal reversing member and a counter electrode disposed opposite the reversing member; and
a surface of the reversing member is covered with the light guide layer.

16. The input device according to Claim 15, wherein an optical element for scattering light or yielding a fluorescence is disposed in at least a portion of the light guide layer.

17. The input device according to Claim 16, wherein the optical element is any one of a scattering substance, a fluorescent substance and a prism.

18. The input device according to Claim 15, wherein the optical element is disposed around the switch mechanism.
